# EUROPEAN PATENT SPECIFICATION

(11) **EP 4 513 208 B1**
(45) Date of publication and mention of the grant of the patent: **02.12.2026**
(21) Application number: 23193186.6
(22) Date of filing: 24.08.2023
(51) Int. Cl.: F04B 49/06, F04B 1/03, F04D 15/02, F04D 29/66, F04D 15/00, F04B 17/03, G01R 31/34, G01R 23/16, G05B 23/02

(54) **METHOD AND SYSTEM OF EVALUATING AND CONTROLLING A ROTATING ELECTRICAL MACHINE**
VERFAHREN UND SYSTEM ZUR BEWERTUNG UND STEUERUNG EINER ELEKTRISCHEN DREHMASCHINE
PROCÉDÉ ET SYSTÈME D'ÉVALUATION ET DE COMMANDE D'UNE MACHINE ÉLECTRIQUE TOURNANTE

(43) Date of publication of application: 26.02.2025
(73) Proprietor: GE Energy Power Conversion Technology Limited, Rugby, Warwickshire CV21 1BD (GB)
(72) Inventor: SINGH, Megha, 600032 Chennai (IN); THIRUNAVUKKARASU, Srinivasan, 600032 Chennai (IN); MANI, Harikrishan, 600032 Chennai (IN)
(74) Representative: Serjeants LLP

(56) References cited:
- EP-A1- 1 298 511
- US-A1- 2005 021 301
- US-A1- 2011 241 888
- US-B1- 6 709 240

## Description

### FIELD OF THE DISCLOSURE

The present disclosure relates to diagnosis of rotating electrical machines and, more specifically, to a system and method of evaluating diagnostic status of a motor-pump pair, wherein the pump corresponds to a centrifugal pump.

### BACKGROUND OF THE DISCLOSURE

Rotating electrical machines have a wide variety of applications, as they are designed for converting mechanical energy into electrical energy, or vice versa. One common example of a rotating electrical machine is a pump. A pump is a mechanical device that is used to move pressurized fluids from one location to another. They are widely used in a variety of applications, including but not limited to water treatment, agriculture, manufacturing, and transportation. In fact, owing to their high versatility and efficiency, the pumps are considered the preferred devices for fluids.

However, the operation of pumps, just like that of any other mechanical or electrical device, is prone to various damages, faults, or any other undesired/abnormal conditions, that tends to render them, temporarily or permanently, unfit for operation. These damages, faults, or any other undesired conditions of the pump are sometimes not only difficult to predict or determine, but the corrective action against them is often difficult carry-out. For example, when abnormal operating condition is determined, the system is required to be shut down, in order to carry out the corrective action or maintenance, leading to shut down or downtime, which is clearly not desirable. Moreover, if the occurrence of an abnormal operating condition is not detected in time, it may lead to the failure of the system, again leading to undesired downtime.

Cavitation is one of the main problems with pumps, in which the flow of the fluid is disrupted by the formation and collapse of vapor bubbles. This can result in reduced performance and efficiency, as well as damage to the pump components.

This can be caused by a combination of factors, including changes in the fluid characteristics, improper operation of the pump, and damage to the pump components. It can be difficult to predict and prevent, as it can occur suddenly and without warning. Conventionally, the condition of a pump has been assessed by visually inspecting the pump or by performing maintenance on the pump to check for damage or other issues. However, these methods can also be time-consuming and may not be very effective. Different solutions have been proposed to overcome the above-mentioned problems; for example, the patent document US 2005/021301 A1 discloses a system and method for proactively determining motor wellness arising from potential mechanical faults of the motor. In US 2005/021301 A1, a processor is configured to acquire current spectrum data from the given motor during operation, map at least one from a plurality of load bins based on the load, and generate a mechanical fault signature from the current spectrum. Other examples can be found in the patent documents US 6 709 240 B1, US 2011/241888 A1, and EP 1 298 511 A1 disclosing alternative methods and apparatuses for detecting cavitation in centrifugal pumps.

### SUMMARY OF THE DISCLOSURE

In view of the foregoing disadvantages inherent in the prior art, the general purpose of the present disclosure is to provide a method and a system as defined, respectively, in the independent claims 1 and 10. Further embodiments are defined in their corresponding dependent claims 2-9 and 11-13. Additionally, the description and drawings also present examples, aspects, implementations, non-claimed embodiments, exemplary embodiments, etc. for the better understanding of the invention as defined by the embodiments disclosed by the appended claims.

The present invention relates to rotating electrical machines formed by a motor-pump pair, wherein the pump corresponds to a centrifugal pump.

In light of the above, in embodiments of the present disclosure, a method for evaluating the status of a motor-pump pair is disclosed in claims 1-9.

In one embodiment of the present disclosure, the first fault indicator in the power spectrum includes presence of low frequency energies in the power spectrum.

In one embodiment of the present disclosure, the second fault indicator is cavitation energies in the current spectrum.

In one embodiment of the present disclosure, the anomalous status in the motor-pump pair includes cavitation in the centrifugal pump.

In one embodiment of the present disclosure, when the low frequency spectrum is determined to be in a first region within a predetermined region, the electrical signature of the motor-pump pair indicates the presence of a first anomalous status in the motor-pump pair. The presence of the first anomalous status indicates the presence of a stall in the motor-pump pair.

In one embodiment of the present disclosure, the presence of the first anomalous status in the low frequency spectrum includes the presence of noise encompassing a wider frequency region.

In one embodiment of the present disclosure, when the low frequency spectrum is determined to be in a second region within the predetermined region, the electrical signature of the motor-pump pair indicates the presence of a second anomalous status in the motor-pump pair. The presence of the second anomalous status indicates the presence of cavitation in the centrifugal pump.

In one embodiment of the present disclosure, the presence of the second anomalous status in the low frequency spectrum includes the presence of a narrower frequency region, less than half of a frequency region corresponding to the first anomalous status.

In light of the above, in other embodiments of the present disclosure, a system for controlling operation of a rotating electrical machine is disclosed in claims 10-13.

In one embodiment of the present disclosure, the anomalous status in the motor-pump pair includes the presence of a stall in the motor-pump pair and/or the presence of cavitation in the centrifugal pump.

In one embodiment of the present disclosure, the anomalous status in the motor-pump pair is determined to be the presence of a stall in the motor-pump pair, when the low frequency spectrum includes the presence of noise encompassing a wider frequency region.

In one embodiment of the present disclosure, the anomalous status in the rotating electrical machine is determined to be the presence of cavitation in the centrifugal pump, when the low frequency spectrum includes the presence of a narrower frequency region, less than half of a frequency region corresponding to the presence of a stall in the motor-pump pair. For a better understanding of the present disclosure, its operating advantages, and the specified object attained by its uses, reference should be made to the accompanying drawings and descriptive matter in which there are illustrated exemplary embodiments of the present disclosure.

### BRIEF DESCRIPTION OF THE DRAWINGS

The advantages and features of the present disclosure will become better understood with reference to the following detailed description and claims taken in conjunction with the accompanying drawings, wherein like elements are identified with like symbols, and in which:
FIGS. 1A and 1B, illustrate schematic views of a system for evaluating status of a rotating electrical machine, in accordance with an embodiment of the present disclosure;
FIG. 2 illustrates a system of controlling operation of the rotating electrical machine, in accordance with an embodiment of the present disclosure;
FIG. 2A illustrates a schematic block diagram of the system of controlling operation of the rotating electrical machine, in accordance with an embodiment of the present disclosure;
FIG. 2B illustrates a system of controlling operation of the rotating electrical machine, in accordance with an embodiment of the present disclosure;
FIG. 3 illustrates a flow chart of the method of evaluating the status of the rotating electrical machine, in accordance with an embodiment of the present disclosure;
FIG. 4 illustrates a graph showing two data points captured with cavitation and without cavitation, in accordance with an embodiment of the present disclosure;
FIG. 5 illustrates fault index for cavitation for a given flow rate plotted with respect to the time, in accordance with an embodiment of the present disclosure;
FIG. 6 illustrates a schematic block diagram of the system of controlling operation of the rotating electrical machine, in accordance with an embodiment of the present disclosure;
FIG. 7A, FIG. 7B, and FIG. 7C illustrate graphs showing first fault indicators at different flow rates, in accordance with an exemplary embodiment of the present disclosure; and
FIG. 8A, FIG. 8B and FIG. 8C illustrate graphs showing second fault indicators at different flow rates, in accordance with an exemplary embodiment of the present disclosure.

Like reference numerals refer to like parts throughout the description of several views of the drawings.

### DETAILED DESCRIPTION OF THE DISCLOSURE

For a thorough understanding of the present disclosure, reference is to be made to the following detailed description, including the appended claims, in connection with the above-described drawings. Although the present disclosure is described in connection with exemplary embodiments, the present disclosure is not intended to be limited to the specific forms set forth herein. In this respect, the invention is defined by the appended claims. Also, it is to be understood that the phraseology and terminology used herein is for the purpose of description and should not be regarded as limiting. The use of "including," "comprising," or "having" is meant to encompass the items listed thereafter.

The terms, "a" and "an" herein do not denote a limitation of quantity, but rather denote the presence of at least one of the referenced items.

The present disclosure provides a system and method of evaluating the status of a rotating electrical machine formed by a motor-pump pair, wherein the pump corresponds to a centrifugal pump. The present disclosure also provides a system for controlling the operation of the rotating electrical machine based on the status of the machine. The method of the present disclosure facilitates the detection of anomalous status in the rotating electrical machine. On the other hand, the system of the present disclosure allows taking control action upon detection of the anomalous status in the rotating electrical machine. Therefore, the present disclosure reduces or eliminates the possibility of failure in the machine, by ensuring that the operation of the machine is not outside of undesirable ranges of operating condition.

In light of the above, in one aspect of the present disclosure, a method for evaluating the status of a rotating electrical machine is disclosed. The method includes capturing, via a signal generator, input signals from the rotating electrical machine during operation thereof. The method further includes converting, via an Analog-to-Digital converter, the input signals to a digital format to create an electrical signature of the rotating electrical machine. The method further includes analyzing, using a cavitation detection processing system, the electrical signature to determine the presence of a first fault indicator in the power spectrum. The method further includes analyzing, using the cavitation detection processing system, the electrical signature to determine the presence of a second fault indicator in a current spectrum. The method further includes determining the anomalous status in the rotating electrical machine based on presence of each of the first fault indicator and the second fault indicator in the respective spectrums of the rotating electrical machine.

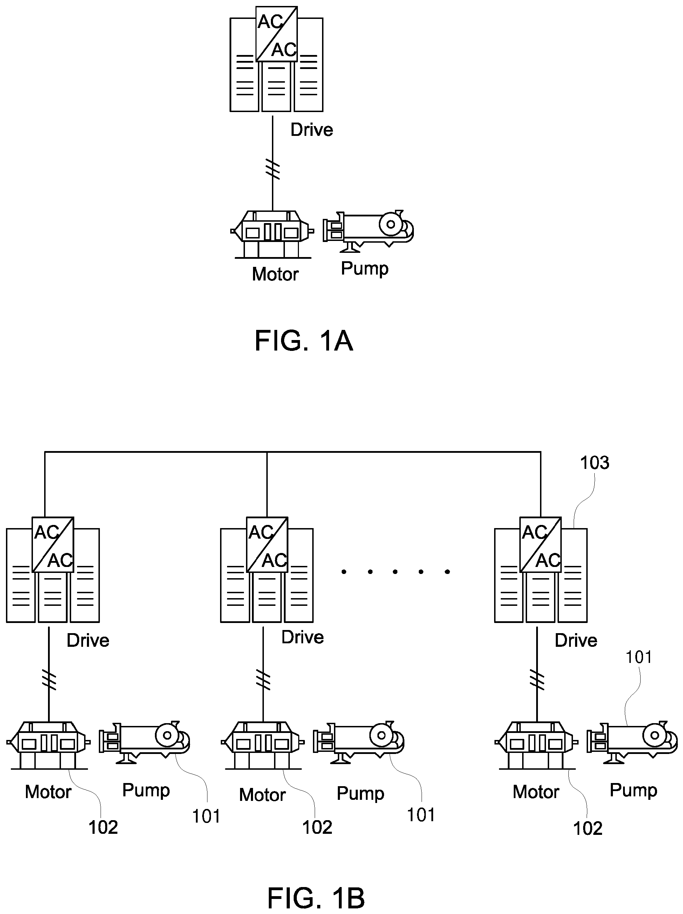

Referring now to FIGS. 1A and 1B, schematic views of an exemplary setup for the method or the system of evaluating the status of a rotating electrical machine 100, in accordance with an embodiment of the present disclosure.

The rotating electrical machine 100 in accordance with an embodiment of the present disclosure may comprise a pump 101. The pump 101 may be a centrifugal pump. However, without departing from the scope of the present disclosure, in alternative embodiments, the pump 101 may be of any kind, such as a centrifugal pump, a vane pump, a gear pump, etc., and may have different sizes. It may however be noted that in other embodiments of the present disclosure, the rotating electrical machine may be any machine other than the pump.

In the disclosed setup, a plurality of rotating electrical machines 100 may be provided. Three pumps 101 are illustrated in FIG. 1A. However, this is an exemplary setup, and in various other exemplary setups, there may be more or a smaller number of pumps. Associated with each pump 101 is a corresponding motor, such as a motor 102, forming a motor-pump pair.

The motor-pump pairs may be connected to respective drive units 103 which are in turn connected to a data acquisition unit 104. The data acquisition unit 104 may be adapted to drive each of the motor-pump pairs, via the respective drive units 103. At the same time, the data acquisition unit 104 may also be adapted to record and store high frequency electrical signals arising from the operation of each of the motor-pump pairs.

The data acquisition unit 104 may be in communication with each of the computers also referred to as a local computer, or processing system, not illustrated, and a cloud-based storage or processing unit drives each of the motor-pump pairs. In an example, the data acquisition unit 104 drives and controls the motor-pump pairs and stores electrical signatures in the form of two voltages and two current signals.

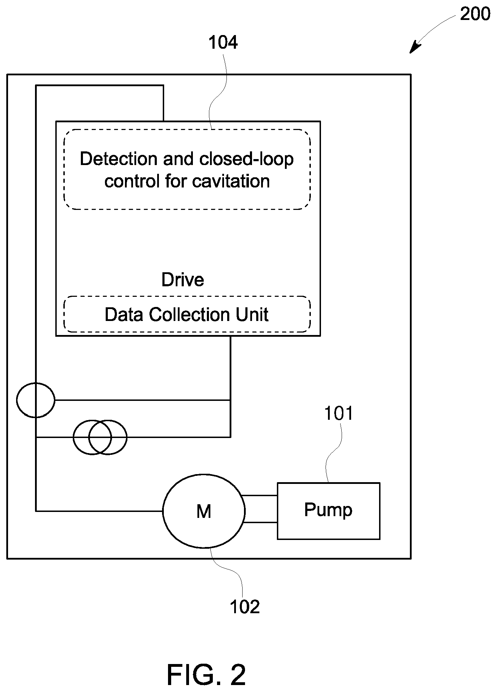

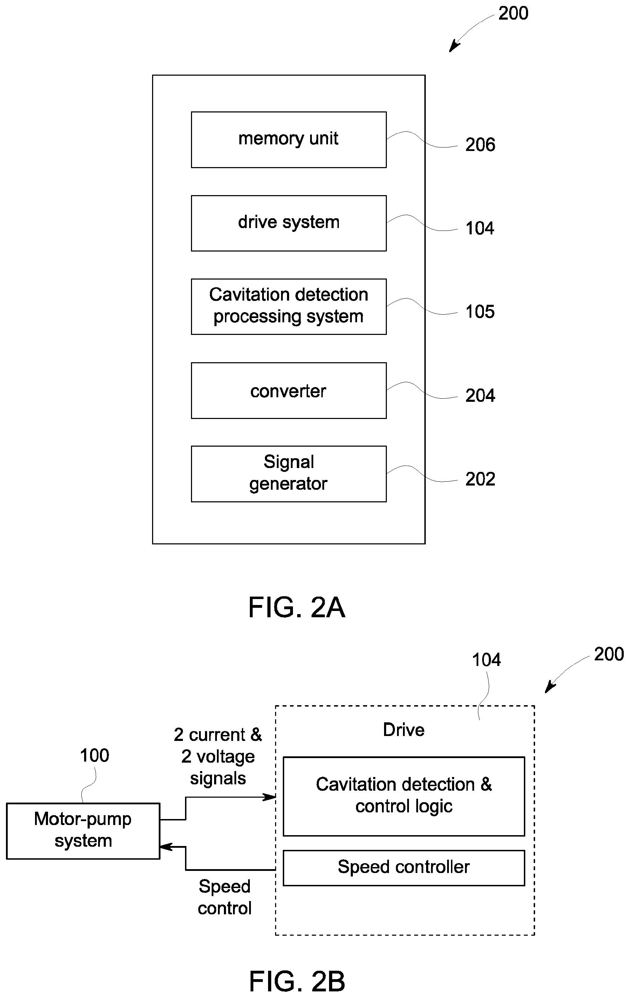

Referring now to FIG. 2 and 2A, illustrating a system 200 of controlling operation of the rotating electrical machine 100, also interchangeably referred to as the system 200. The system 200 includes a signal generator 202 for generating input signals from the rotating electrical machine 100. In an example, some common types of signals that may be used may include sinusoidal signals, square waves, and pulse-width modulated PWM signals. The signal generator 202 may be programmed to produce a range of frequencies and amplitudes, allowing for a variety of different test scenarios. In an example, the signal generator 202 may be a frequency generator, adapted to produce sine, square, and triangle waveforms at a wide range of frequencies.

The system 200 further includes a converter 204 for converting the input signals to a digital format to create an electrical signature of each of the rotating electrical machines. In an example, the converter 204 may be an analog-to-digital converter (or ADC), which converts an analog input signal to a digital representation by sampling the input at regular intervals and quantizing the samples into a digital representation. The resolution of the ADC, or the number of bits used to represent each sample, determines the accuracy of the digital representation. Alternatively, the converter 204 may be a digital oscilloscope, which measures and displays electrical signals. Basically, the digital oscilloscope converts the input signal into a digital format and displays it on a screen in the form of a graph. As such the displayed electrical signals represent computed total energy as a frequency spectrum. at the time of experiment.

The system 200 further includes a cavitation detection processing system 105 for analyzing the electrical signature of one or more of the rotating electrical machines 100. The cavitation detection processing system 105 may include a software or an algorithm to determine the faults in the rotating electrical machines 100. The cavitation detection processing system 105 may be capable of analyzing, using such software program or algorithm, the electrical signature to determine the presence of a first fault indicator in the power spectrum; and analyzing, using such software program or algorithm, the electrical signature to determine the presence of a second fault indicator in the current spectrum. When the electrical signature of the rotating electrical machine indicates presence of each of the first fault indicator and the second fault indicator in the respective spectrums, an anomalous status in the rotating electrical machine may be determined. In an embodiment, the first fault indicator in the power spectrum includes presence of low frequency energies in power spectrum. Further, the second fault indicator is cavitation energies in the current spectrum. Specifically, in an example, the rotating electrical machine includes a pump, and the anomalous status in the rotating electrical machine includes cavitation in the pump.

In another embodiment, the cavitation detection processing system determines the presence of a noise at low frequency spectrum in the electrical signature. When the low frequency spectrum may be determined to be in a predetermined region, the electrical signature of the rotating electrical machine 100 indicates the presence of an anomalous status in the rotating electrical machine. A total computed energy may be multiplied with a pre-defined multiplier by the cavitation detection processing system, for better visualization purposes.

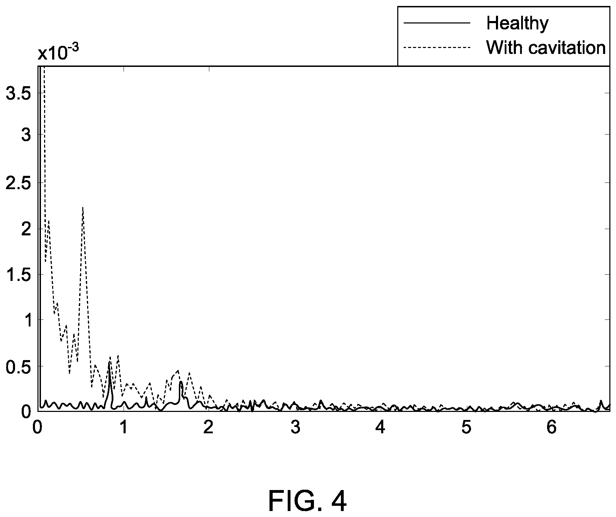

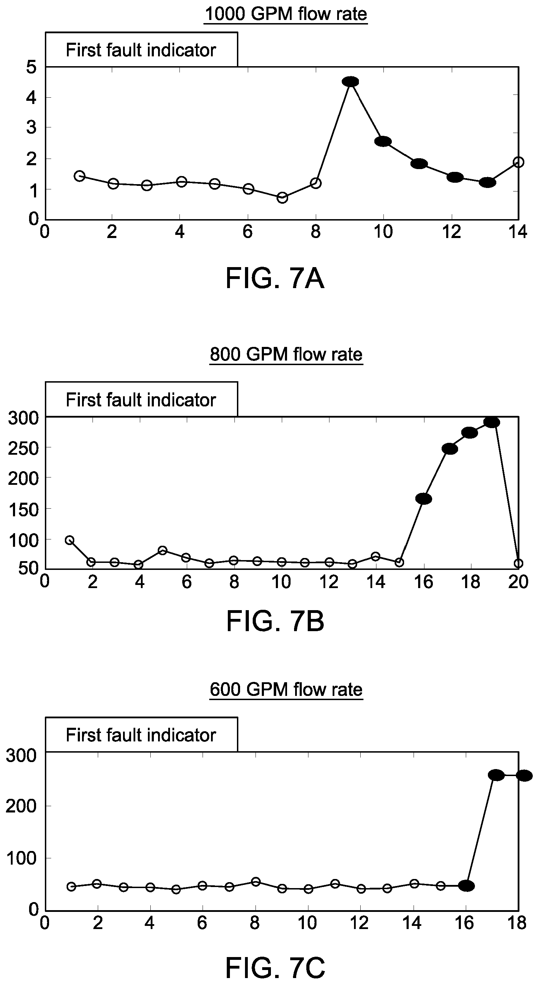

FIG. 4, illustrates the graph showing the electrical signatures of the rotating electrical machines, that are healthy, or have cavitation. The axis labels and values along the X-axis and Y-axis shown in FIG. 4 are only for understanding purpose and that such axis labels and values shall not be considered to be limiting only to such labels and values. FIG. 7A, FIG. 7B, and FIG. 7C, illustrate graphs showing the first fault indicators, at different flow rates. Specifically, FIG. 7A provides a graph illustrating the first fault indicators at 1000 GPM flow rate, which corresponds to 0,06309 m³/s in International System. Fig. 7B provides a graph illustrating the first fault indicators at 800 GPM flow rate (0,05047 m³/s, in International System). FIG. 7C provides a graph illustrating the first fault indicators at 600 GPM flow rate (0,03785 m3/s, in International System). Similar to FIG. 4, the axis labels and values along the X-axis and Y-axis shown in FIGS. 7A-7C are only for understanding purpose and that such axis labels and values shall not be considered to be limiting only to such labels and values.

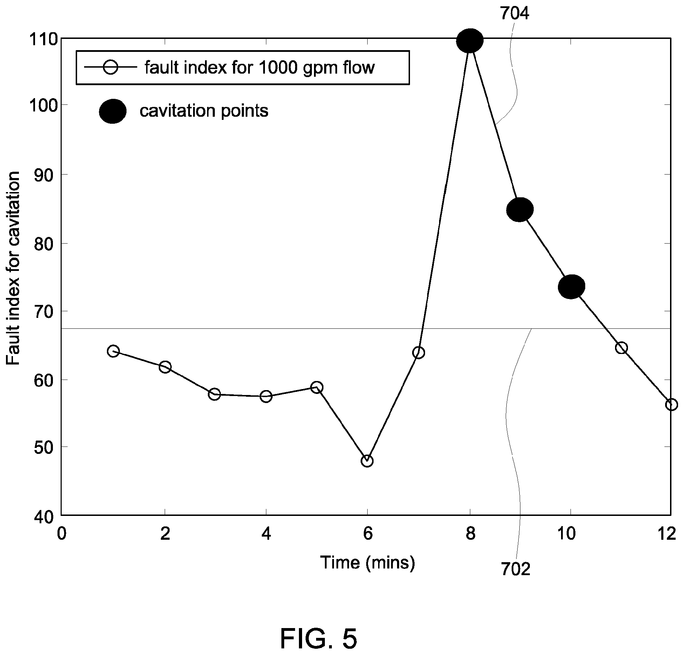

If we plot a graph of the final computed total energy within a specified band plotted for each acquired electrical data points over a period of time. The graph includes a fault threshold line and a fault index. The rotating stall may be observed towards the end of x-axis, i.e., at the end of pump operation. The higher values are observed for stall phase for the pump. FIG. 5, illustrates the computed total energy of identified cavity electrical signatures plotted with respect to the time of the experiment. The graph includes a fault threshold line 702 and a fault index 704. In the illustrated experiment, the cavity was induced in the pump at 7^{th} minute of the experiment, which may be depicted in the computed energy being high. Without departing from the scope of the present disclosure, the axis labels and values along the X-axis and Y-axis as shown in FIG. 5 are only for understanding purpose and that such axis labels and values shall not be considered to be limiting only to such labels and values as depicted.

In an example, the predetermined region of the electrical signature may be demarked by the fault threshold line or the fault threshold line 702. In such an example, when the fault index or the fault index 704 crosses the respective fault threshold line, the electrical signature signifies the presence of the low-frequency spectrum in the predetermined region. This indicates the presence of the anomalous status in the rotating electrical machine 100.

The fault threshold line or the fault threshold line 702 may be altered moved up or down based on various factors, such as size, of the rotating electrical machine 100. In an example, the cavitation detection processing system may be adapted to receive inputs regarding the fault threshold line and/or the fault threshold line 702. In another example, the cavitation detection processing system may also be adapted to automatically determine the fault threshold line and/or the fault threshold line 702. In either of the aforementioned examples, by calculating the fault threshold line and/or the fault threshold line 702, the cavitation detection processing system also determines the predetermined region corresponding to a given rotating electrical machine 100.

In an example, the predetermined region refers to a region in graph wherein the computed total energy of a given signature may be above a fault threshold or above a preselected threshold.

In another example, the first region of the electrical signature may be demarked by the fault threshold line. In such an example, when the fault index crosses the fault threshold line, the electrical signature signifies the presence of the low-frequency spectrum in the first region. This indicates the presence of the first anomalous status in the rotating electrical machine 100.

In the same manner, the second region of the electrical signature may be demarked by the fault threshold line 702. In such an example, when the fault index 704 crosses the fault threshold line 702, the electrical signature signifies the presence of the low-frequency spectrum in the second region. This indicates the presence of the second anomalous status in the rotating electrical machine 100.

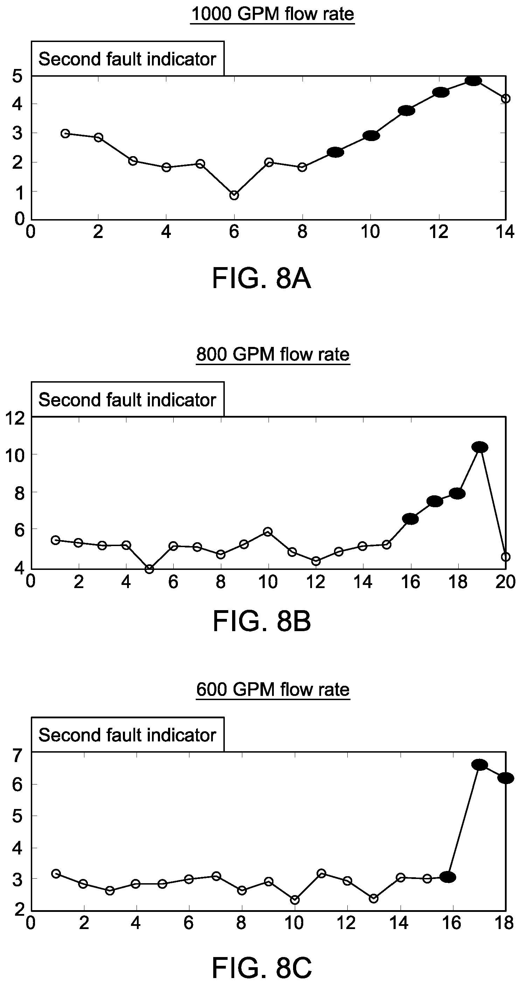

FIG. 8A, FIG. 8B, and FIG. 8C, illustrate graphs showing the second fault indicators, at different flow rates. Specifically, FIG. 8A provides a graph illustrating the second fault indicators at 1000 GPM flow rate (0,06309 m3/s, in International System). FIG. 8B provides a graph illustrating the second fault indicators at 800 GPM flow rate (0,05047 m3/s, in International System). FIG. 8C provides a graph illustrating the second fault indicators at 600 GPM flow rate (0,03785 m3/s, in International System). Without departing from the scope of the present disclosure, the axis labels and values along the X-axis and Y-axis shown in FIGS. 8A-8C are only for understanding purpose and that such axis labels and values shall not be considered to be limiting only to such labels and values as depicted.

The system 200 further includes the drive system 104 shown in FIG. 2. The drive system 104 may be configured to control the rotating electrical machine 100. The drive system 104 may be in communication with the cavitation detection processing system and performs a control action. The control action includes closed-loop control, such that the control action includes sending a trigger signal based on the analysis of the electrical signature to marginally reduce an operating speed of the rotating electrical machine 100. Subsequent to this, the cavitation detection processing system continuously analyses the electrical signature after every trigger signal is executed. Further, the cavitation detection processing system continues to send the trigger signal to the drive system 104 as long as there is the presence of a noise at low frequency spectrum, and the low-frequency spectrum remains in a predetermined region.

The anomalous status in the rotating electrical machine 100 may include the presence of a stall in the rotating electrical machine 100. The anomalous status in the rotating electrical machine 100 may further include the presence of cavitation in the rotating electrical machine 100.

In various embodiments, the anomalous status in the rotating electrical machine 100 may be determined to be the presence of a stall in the rotating electrical machine 100, when the low-frequency spectrum includes the presence of noise encompassing a wider frequency region. This anomalous status may be referred to as a first anomalous status. Further, the anomalous status in the rotating electrical machine 100 is determined to be the presence of cavitation in the rotating electrical machine 100, when the low-frequency spectrum includes the presence of a narrower frequency region, less than half of the frequency region corresponding to the presence of a stall in the rotating electrical machine 100. This anomalous status may be referred a second anomalous status. It may herein be noted that the presence of the term first, and second does not indicate order, or priority or quantity, but rather denote the presence of at least one of the referenced anomalies.

The system 200 further includes a memory unit 206 in communication with the cavitation detection processing system. The memory unit 206 is adapted to store historical data.

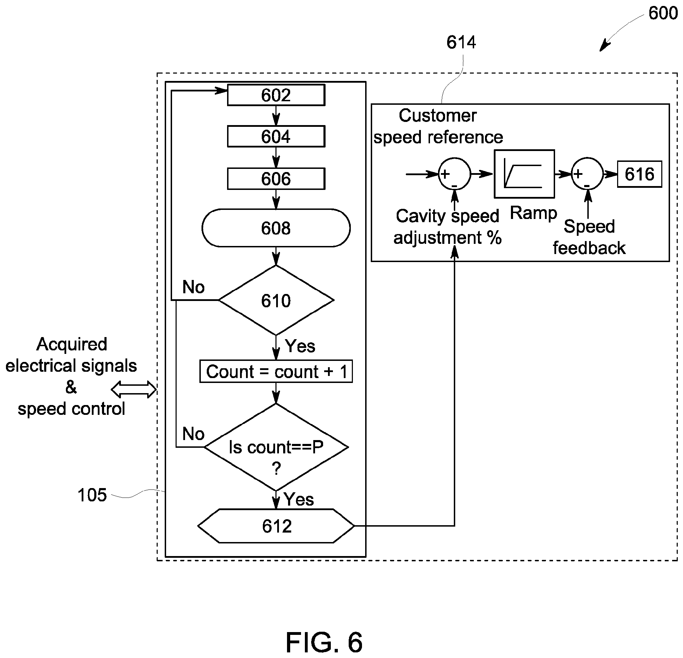

Another embodiment of the system 600 of controlling operation of the rotating electrical machine 100, is illustrated in FIG. 6. The system 600 is adapted to perform the signal pre-processing, at block 602, perform power & current spectrum calculation 604, and determine energy computation 606. In an embodiment, the cavitation detection processing system is used for performing the signal pre-processing 602, performing power & current spectrum calculation 604, and determination of energy computation 606, as a part of analyzing the electrical signature of one or more of the rotating electrical machines 100. Subsequently, the system 200, at block 608 determines a cavity fault indexes as a multiple of computed energies from power & current spectrum. When, at block 610 the computed energy is determined to be below the pre-defined threshold, the process of performing the signal pre-processing, performing power & current spectrum calculation, and determining energy computation is performed. On the other hand, when the computed energy is determined to be above the pre-defined threshold, a reduction in the reference speed by a predetermined percentage is performed at block 612.

It may herein be noted that the number of points above cavity threshold needed to confirm cavitation, and the speed percentage to be reduced from operating speed, can be configurable values. Further, this process continues until cavity is below threshold or lower limit of pump speed is reached, or the pump speed cannot be further reduced.

At block 614, with the value for reduction in the reference speed i.e., the cavity speed adjustment percentage, in conjunction with the customer speed reference, is passed through ramp function and with speed feedback to the speed controller at 616.

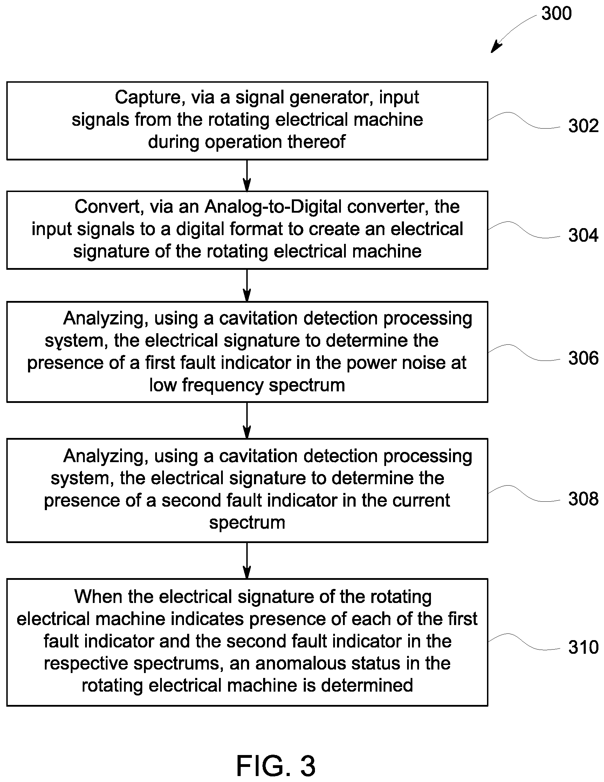

Referring now to FIG. 3, illustrating a method 300 of evaluating the status of the rotating electrical machine 100. The method 300 comprises, at step 302, capturing, via a signal generator, input signals from the rotating electrical machine during operation thereof. The method 300, at step 304 comprises, converting, via an Analog-to-Digital converter, the input signals to a digital format to create an electrical signature of the rotating electrical machine.

Subsequently, the method 300 includes analyzing, using the cavitation detection processing system 105 that may include a software or an algorithm, the electrical signature to determine the determine the presence a first fault indicator in the power noise at low frequency spectrum; spectrum, at step 306. At step 308, the method 300 includes analyzing, using such software program or algorithm, the electrical signature to determine the presence of a second fault indicator in the current spectrum. Post such analysis, at step 310, when the electrical signature of the rotating electrical machine indicates presence of each of the first fault indicator and the second fault indicator in the respective spectrums, an anomalous status in the rotating electrical machine is determined

In other words, if the low frequency spectrum is determined to be in a first region, the electrical signature of the rotating electrical machine indicates the presence of the first anomalous status in the rotating electrical machine. On the other hand, if the low frequency spectrum is determined to be in a second region, the electrical signature of the rotating electrical machine indicates the presence of the second anomalous status in the rotating electrical machine.

In light of the foregoing, the present disclosure provides various advantages, for example, the present disclosure uses electrical feedback signal-based control mechanism for controlling cavitation of the pump, and precludes a need of human intervention to perform that control action. Accordingly, the present disclosure reduces or eliminates unscheduled shutdowns and thereby ensure continues uninterrupted operation. In addition, the present disclosure enables users to be able to detect abnormal operating conditions or damage to the rotating electrical machines, without having to rely on direct physical measurement of pump pressure and flow. Further, by utilizing both the fault indicators, the present disclosure eliminates the false positives.

The foregoing descriptions of specific embodiments of the present disclosure have been presented for purposes of illustration and description. They are not intended to be exhaustive or to limit the present disclosure to the precise forms disclosed. In this respect, the scope of the invention is defined by the appended claims.

## Claims

1. A method (300) of evaluating status of a motor-pump pair (100) comprising a centrifugal pump (101) that is associated with a corresponding motor (102),
the method comprising: producing, by a signal generator (202), signals used to allow the test scenario for the motor-pump pair (100);
capturing (302), via the e signal generator (202), at least two voltage signals and at least two current signals from the motor-pump pair (100) during operation thereof; converting (304), via an Analog-to-Digital converter (204), the at least two voltage signals and the at least two current signals to a digital format to create an electrical signature of the motor-pump pair (100);
performing, using a cavitation detection processing system (105), a power spectrum calculation and a current spectrum calculation on the electrical signature to calculate a power spectrum and a current spectrum;
analyzing (306), using the cavitation detection processing system (105), a first region of the electrical signature to determine the presence of a first fault indicator in the power spectrum based on when a fault index crosses a fault threshold line; and
analyzing (308), using the cavitation detection processing system (105), a second region of the electrical signature to determine the presence of a second fault indicator in the current spectrum based on when the fault index crosses the fault threshold line,
wherein an anomalous status in the motor-pump pair (100) is determined (310) based on presence of each of the first fault indicator and the second fault indicator in the respective power and current spectrums of the motor-pump pair (100); and
continuously analyzing, using the cavitation detection processing system (105), the electrical signature, and performing a closed-loop control on the motor-pump pair (100) continuously with decreasing speeds as long as the presence of each of the first fault indicator and the second fault indicator is detected.

2. The method (300) as claimed in claim 1, wherein the first fault indicator in the power spectrum includes the presence of low frequency energies in the power spectrum.

3. The method (300) as claimed in claim 1 or claim 2, wherein the second fault indicator is cavitation energies in the current spectrum and the anomalous status in the motor-pump pair (100) includes cavitation in the centrifugal pump (101).

4. The method (300) as claimed in claim 2, wherein when the low frequency spectrum is determined to be in a first region within a predetermined region, the electrical signature of the motor-pump pair (100) indicates the presence of a first anomalous status in the motor-pump pair (100), the presence of the first anomalous status indicates the presence of a stall in the motor-pump pair (100).

5. The method (300) as claimed in claim 4, wherein the presence of the first anomalous status in the low frequency spectrum includes the presence of noise encompassing a wider frequency region.

6. The method (300) as claimed in claim 4 or claim 5, wherein when the low frequency spectrum is determined to be in a second region within the predetermined region, the electrical signature of the motor-pump pair (100) indicates the presence of a second anomalous status in the motor-pump pair (100), the presence of the second anomalous status indicates the presence of cavitation in the centrifugal pump (101).

7. The method (300) as claimed in claim 6, wherein the presence of the second anomalous status in the low frequency spectrum includes the presence of a narrower frequency region, less than half of the frequency region corresponding to the first anomalous status.

8. The method (300) as claimed in any preceding claim, wherein the at least two voltage signals and the at least two current signals from the motor-pump pair (100) are measured when the motor-pump pair (100) is operating on multiple voltage and multiple current signals.

9. The method (300) as claimed in any preceding claim, wherein the step of capturing (302), via a signal generator (202), the at least two voltage signals and the at least two current signals from the motor-pump pair (100) during operation thereof is performed at multiple instances, using different flow rates of the centrifugal pump (101).

10. A system of controlling operation of a motor-pump pair (100) comprising a centrifugal pump (101) that is associated with a corresponding motor (102), the system comprising:
a signal generator (202) configured to produce signals used to allow the test scenario for the motor-pump pair (100), and to capture at least two voltage signals and at least two current signals from the motor-pump pair (100) during operation thereof;
an Analog-to-Digital converter (204) configured to convert the at least two voltage signals and the at least two current signals to a digital format to create an electrical signature of the motor-pump pair (100);
a cavitation detection processing system (105) configured to:
perform a power spectrum calculation and a current spectrum calculation on the electrical signature to calculate a power spectrum and a current spectrum;
analyze a first region of the electrical signature to determine the presence of a first fault indicator in the power spectrum based on when a fault index crosses a fault threshold line; and
analyze a second region of the electrical signature to determine the presence of a second fault indicator in the current spectrum based on when the fault index crosses the fault threshold, wherein an anomalous status in the motor-pump pair (100) is determined based on presence of each of the first fault indicator and the second fault indicator in the respective power and current spectrums of the motor-pump pair (100), and
a drive system (104) configured to control the motor-pump pair (100), the drive system (104) being in communication with the cavitation detection processing system (105);
wherein the cavitation detection processing system (104) is further configured to send a trigger signal based on the analysis of the electrical signature to the drive unit (104) to reduce an operating speed of the motor-pump pair (100); and
wherein the cavitation detection processing system (105) is further configured to continuously analyze the electrical signature after every trigger signal is sent, and to continue to send the trigger signal to the drive system (104) as long as the presence of each of the first fault indicator and the second fault indicator is detected.

11. The system of controlling operation of the motor-pump pair (100) as claimed in claim 10, wherein the anomalous status in the motor-pump pair (100) includes the presence of a stall in the motor-pump pair (100) and/or the presence of cavitation in the centrifugal pump (101).

12. The system of controlling operation of the motor-pump pair (100) as claimed in claim 10 or claim 11, wherein the anomalous status in the motor-pump pair (100) is determined to be the presence of a stall in the motor-pump pair (100), when the low frequency spectrum includes the presence of noise encompassing a wider frequency region.

13. The system of controlling operation of the motor-pump pair (100) as claimed in any of claims 10 to 12, wherein the anomalous status in the motor-pump pair (100) is determined to be the presence of cavitation in the centrifugal pump (101), when the low frequency spectrum includes the presence of a narrower frequency region, less than half of a frequency region corresponding to the presence of a stall in the motor-pump pair (100).

## Patentansprüche

1. Verfahren (300) zur Bewerten des Zustands eines Motor-Pumpen-Paares (100), umfassend eine Kreiselpumpe (101), die mit einem entsprechenden Motor (102) verknüpft ist, wobei das Verfahren Folgendes umfasst:
Erzeugen, durch einen Signalgenerator (202), von Signalen, die verwendet werden, um das Testszenario für das Motor-Pumpen-Paar (100) zu ermöglichen;
Erfassen (302), über den Signalgenerator (202), von mindestens zwei Spannungssignalen und mindestens zwei Stromsignalen vom Motor-Pumpen-Paar (100) während dessen Betriebs;
Umwandeln (304), über einen Analog-Digital-Wandler (204), der mindestens zwei Spannungssignale und der mindestens zwei Stromsignale in ein digitales Format, um eine elektrische Signatur des Motor-Pumpen-Paares (100) zu erzeugen;
Durchführen, unter Verwendung eines Kavitationserkennungsverarbeitungssystems (105), einer Leistungsspektrumsberechnung und einer Stromspektrumsberechnung an der elektrischen Signatur, um ein Leistungsspektrum und ein Stromspektrum zu berechnen;
Analysieren (306), unter Verwendung des Kavitationserkennungsverarbeitungssystems (105), eines ersten Bereichs der elektrischen Signatur, um das Vorhandensein eines ersten Fehlerindikators im Leistungsspektrum zu bestimmen, auf Grundlage dessen, wann ein Fehlerindex eine Fehlerschwellenlinie überschreitet; und
Analysieren (308), unter Verwendung des Kavitationserkennungsverarbeitungssystems (105), eines zweiten Bereichs der elektrischen Signatur, um das Vorhandensein eines zweiten Fehlerindikators im Stromspektrum zu bestimmen, auf Grundlage dessen, wann der Fehlerindex die Fehlerschwellenlinie überschreitet,
wobei ein anomaler Zustand im Motor-Pumpen-Paar (100) auf Grundlage des Vorhandenseins des ersten und des zweiten Fehlerindikators in den jeweiligen Leistungs- und Stromspektren des Motor-Pumpen-Paares (100) ermittelt wird (310); und
kontinuierliches Analysieren, unter Verwendung des Kavitationserkennungsverarbeitungssystems (105), der elektrischen Signatur und Durchführen einer Regelung an dem Motor-Pumpen-Paar (100) kontinuierlich mit abnehmenden Drehzahlen, solange das Vorhandensein des ersten Fehlerindikators und des zweiten Fehlerindikators erkannt wird.

2. Verfahren (300) nach Anspruch 1, wobei der erste Fehlerindikator im Leistungsspektrum das Vorhandensein niederfrequenter Energien im Leistungsspektrum einschließt.

3. Verfahren (300) nach Anspruch 1 oder Anspruch 2, wobei der zweite Fehlerindikator Kavitationsenergien im Stromspektrum ist und der anomale Zustand im Motor-Pumpen-Paar (100) Kavitation in der Kreiselpumpe (101) einschließt.

4. Verfahren (300) nach Anspruch 2, wobei, wenn festgestellt wird, dass sich das Niederfrequenzspektrum in einem ersten Bereich innerhalb eines vorbestimmten Bereichs befindet, die elektrische Signatur des Motor-Pumpen-Paares (100) das Vorhandensein eines ersten anomalen Zustands im Motor-Pumpen-Paar (100) anzeigt, wobei das Vorhandensein des ersten anomalen Zustands das Vorhandensein eines Stillstands im Motor-Pumpen-Paar (100) anzeigt.

5. Verfahren (300) nach Anspruch 4, wobei das Vorhandensein des ersten anomalen Zustands im Niederfrequenzspektrum das Vorhandensein von Rauschen einschließt, das einen breiteren Frequenzbereich beinhaltet.

6. Verfahren (300) nach Anspruch 4 oder Anspruch 5, wobei, wenn festgestellt wird, dass sich das Niederfrequenzspektrum in einem zweiten Bereich innerhalb des vorbestimmten Bereichs befindet, die elektrische Signatur des Motor-Pumpen-Paares (100) das Vorhandensein eines zweiten anomalen Zustands im Motor-Pumpen-Paar (100) anzeigt, wobei das Vorhandensein des zweiten anomalen Zustands das Vorhandensein von Kavitation in der Kreiselpumpe (101) anzeigt.

7. Verfahren (300) nach Anspruch 6, wobei das Vorhandensein des zweiten anomalen Zustands im Niederfrequenzspektrum das Vorhandensein eines schmaleren Frequenzbereichs einschließt, weniger als die Hälfte des Frequenzbereichs, der dem ersten anomalen Zustand entspricht.

8. Verfahren (300) nach einem vorstehenden Anspruch, wobei die mindestens zwei Spannungssignale und die mindestens zwei Stromsignale des Motor-Pumpen-Paares (100) gemessen werden, wenn das Motor-Pumpen-Paar (100) mit mehreren Spannungs- und mehreren Stromsignalen arbeitet.

9. Verfahren (300) nach einem vorstehenden Anspruch, wobei der Schritt des Erfassens (302), über einen Signalgenerator (202), der mindestens zwei Spannungssignale und der mindestens zwei Stromsignale des Motor-Pumpen-Paares (100) während dessen Betriebs zu mehreren Gelegenheiten, unter Verwendung unterschiedlicher Fördermengen der Kreiselpumpe (101), durchgeführt wird.

10. System zum Steuern des Betriebs eines Motor-Pumpen-Paares (100), umfassend eine Kreiselpumpe (101), die mit einem entsprechenden Motor (102) verknüpft ist, wobei das System Folgendes umfasst:
einen Signalgenerator (202), der dafür konfiguriert ist, Signale zu erzeugen, die verwendet werden, um das Testszenario für das Motor-Pumpen-Paar (100) zu ermöglichen, und mindestens zwei Spannungssignale und mindestens zwei Stromsignale vom Motor-Pumpen-Paar (100) während dessen Betriebs zu erfassen;
einen Analog-Digital-Wandler (204), der dafür konfiguriert ist, die mindestens zwei Spannungssignale und die mindestens zwei Stromsignale in ein digitales Format umzuwandeln, um eine elektrische Signatur des Motor-Pumpen-Paares (100) zu erzeugen;
ein Kavitationserkennungsverarbeitungssystem (105), das zu Folgendem konfiguriert ist:
eine Leistungsspektrumsberechnung und eine Stromspektrumsberechnung an der elektrischen Signatur durchzuführen, um ein Leistungsspektrum und ein Stromspektrum zu berechnen;
einen ersten Bereich der elektrischen Signatur zu analysieren, um das Vorhandensein eines ersten Fehlerindikators im Leistungsspektrum zu bestimmen, auf Grundlage dessen, wann ein Fehlerindex eine Fehlerschwellenlinie überschreitet; und
einen zweiten Bereich der elektrischen Signatur zu analysieren, um das Vorhandensein eines zweiten Fehlerindikators im Stromspektrum zu bestimmen, auf Grundlage dessen, wann der Fehlerindex den Fehlerschwellenwert überschreitet, wobei ein anomaler Zustand im Motor-Pumpen-Paar (100) auf der Grundlage des Vorhandenseins sowohl des ersten Fehlerindikators als auch des zweiten Fehlerindikators in den jeweiligen Leistungs- und Stromspektren des Motor-Pumpen-Paares (100) bestimmt wird, und
ein Ansteuerungssystem (104), das zum Steuern des Motor-Pumpen-Paares (100) konfiguriert ist, wobei das Ansteuerungssystem (104) mit dem Kavitationserkennungsverarbeitungssystem (105) in Verbindung steht;
wobei das Kavitationserkennungsverarbeitungssystem (104) weiter dafür konfiguriert ist, auf Grundlage der Analyse der elektrischen Signatur ein Auslösesignal an die Ansteuerungseinheit (104) sendet, um eine Betriebsdrehzahl des Motor-Pumpen-Paares (100) zu reduzieren; und
wobei das Kavitationserkennungsverarbeitungssystem (105) weiter dafür konfiguriert ist, nachdem jedes Auslösesignal gesendet ist, kontinuierlich die elektrische Signatur zu analysieren und das Auslösesignal so lange an das Ansteuerungssystem (104) zu senden, wie das Vorhandensein des ersten Fehlerindikators und des zweiten Fehlerindikators erkannt wird.

11. System zum Steuern des Betriebs des Motor-Pumpen-Paares (100) nach Anspruch 10, wobei der anomale Zustand im Motor-Pumpen-Paar (100) das Vorhandensein eines Stillstands im Motor-Pumpen-Paar (100) und/oder das Vorhandensein von Kavitation in der Kreiselpumpe (101) einschließt.

12. System zum Steuern des Betriebs des Motor-Pumpen-Paares (100) nach Anspruch 10 oder Anspruch 11, wobei der anomale Zustand im Motor-Pumpen-Paar (100) als das Vorhandensein eines Stillstands im Motor-Pumpen-Paar (100) bestimmt wird, wenn das Niederfrequenzspektrum das Vorhandensein von Rauschen einschließt, das einen breiteren Frequenzbereich beinhaltet.

13. System zum Steuern des Betriebs des Motor-Pumpen-Paares (100) nach einem der Ansprüche 10 bis 12, wobei der anomale Zustand im Motor-Pumpen-Paar (100) als das Vorhandensein von Kavitation in der Kreiselpumpe (101) bestimmt wird, wenn das Niederfrequenzspektrum das Vorhandensein eines schmaleren Frequenzbereichs einschließt, weniger als die Hälfte eines Frequenzbereichs, der dem Vorhandensein eines Stillstands im Motor-Pumpen-Paar (100) entspricht.

## Revendications

1. Procédé (300) d'évaluation de l'état d'un couple moteur-pompe (100) comprenant une pompe centrifuge (101) associée à un moteur correspondant (102), le procédé comprenant :
la production, par un générateur de signaux (202), de signaux utilisés pour permettre le scénario de test du couple moteur-pompe (100) ;
la capture (302), via le générateur de signaux (202), d'au moins deux signaux de tension et d'au moins deux signaux de courant provenant du couple moteur-pompe (100) pendant son fonctionnement ;
la conversion (304), via un convertisseur analogique-numérique (204), des au moins deux signaux de tension et des au moins deux signaux de courant en un format numérique pour créer une signature électrique du couple moteur-pompe (100) ;
l'exécution, à l'aide d'un système de traitement de détection de cavitation (105), d'un calcul de spectre de puissance et d'un calcul de spectre de courant sur la signature électrique pour calculer un spectre de puissance et un spectre de courant ;
l'analyse (306), à l'aide du système de traitement de détection de cavitation (105), d'une première région de la signature électrique pour déterminer la présence d'un premier indicateur de défaut dans le spectre de puissance en fonction du moment de franchissement, par l'indice de défaut, d'une ligne de seuil de défaut ; et
l'analyse (308), à l'aide du système de traitement de détection de cavitation (105), d'une seconde région de la signature électrique pour déterminer la présence d'un second indicateur de défaut dans le spectre de courant en fonction du moment de franchissement, par l'indice de défaut, d'une ligne de seuil de défaut,
dans lequel un état anormal dans le couple moteur-pompe (100) est déterminé (310) en fonction de la présence de chacun des premier et second indicateurs de défaut dans les spectres de puissance et de courant respectifs du couple moteur-pompe (100) ; et
l'analyse en continu, à l'aide du système de traitement de détection de cavitation (105), de la signature électrique et l'exécution d'une commande en boucle fermée sur le couple moteur-pompe (100) en continu avec des vitesses décroissantes tant que la présence de chacun des premier et second indicateurs de défaut est détectée.

2. Procédé (300) selon la revendication 1, dans lequel le premier indicateur de défaut dans le spectre de puissance inclut la présence d'énergies de basse fréquence dans le spectre de puissance.

3. Procédé (300) selon la revendication 1 ou la revendication 2, dans lequel le second indicateur de défaut est constitué des énergies de cavitation dans le spectre de courant et l'état anormal dans le couple moteur-pompe (100) inclut la cavitation dans la pompe centrifuge (101).

4. Procédé (300) selon la revendication 2, dans lequel lorsqu'il est déterminé que le spectre basse fréquence se situe dans une première région au sein d'une région prédéterminée, la signature électrique du couple moteur-pompe (100) indique la présence d'un premier état anormal dans le couple moteur-pompe (100), la présence du premier état anormal indiquant la présence d'un blocage dans le couple moteur-pompe (100).

5. Procédé (300) selon la revendication 4, dans lequel la présence du premier état anormal dans le spectre basse fréquence inclut la présence de bruit englobant une région de fréquence plus large.

6. Procédé (300) selon la revendication 4 ou la revendication 5, dans lequel, lorsqu'il est déterminé que le spectre basse fréquence se situe dans une seconde région au sein de la région prédéterminée, la signature électrique du couple moteur-pompe (100) indique la présence d'un second état anormal dans le couple moteur-pompe (100), la présence du second état anormal indiquant la présence de cavitation dans la pompe centrifuge (101).

7. Procédé (300) selon la revendication 6, dans lequel la présence du second état anormal dans le spectre basse fréquence inclut la présence d'une région de fréquence plus étroite, inférieure à la moitié de la région de fréquence correspondant au premier état anormal.

8. Procédé (300) selon une quelconque revendication précédente, dans lequel les au moins deux signaux de tension et les au moins deux signaux de courant provenant du couple moteur-pompe (100) sont mesurés lorsque le couple moteur-pompe (100) fonctionne sur plusieurs signaux de tension et plusieurs signaux de courant.

9. Procédé (300) selon une quelconque revendication précédente, dans lequel l'étape de capture (302), via un générateur de signaux (202), des au moins deux signaux de tension et des au moins deux signaux de courant provenant du couple moteur-pompe (100) pendant son fonctionnement est effectuée à plusieurs reprises, en utilisant différents débits de la pompe centrifuge (101).

10. Système de commande du fonctionnement d'un couple moteur-pompe (100) comprenant une pompe centrifuge (101) associée à un moteur correspondant (102), le système comprenant :
un générateur de signaux (202) configuré pour produire des signaux utilisés pour permettre le scénario de test du couple moteur-pompe (100), et pour capturer au moins deux signaux de tension et au moins deux signaux de courant provenant du couple moteur-pompe (100) pendant son fonctionnement ;
un convertisseur analogique-numérique (204) configuré pour convertir les au moins deux signaux de tension et les au moins deux signaux de courant en un format numérique, afin de créer une signature électrique du couple moteur-pompe (100) ;
un système de traitement de détection de cavitation (105) configuré pour :
exécuter un calcul de spectre de puissance et un calcul de spectre de courant sur la signature électrique pour calculer un spectre de puissance et un spectre de courant ;
analyser une première région de la signature électrique pour déterminer la présence d'un premier indicateur de défaut dans le spectre de puissance en fonction du moment de franchissement, par l'indice de défaut, d'une ligne de seuil de défaut ; et
analyser une seconde région de la signature électrique pour déterminer la présence d'un second indicateur de défaut dans le spectre de courant en fonction du moment de franchissement, par l'indice de défaut, d'un seuil de défaut, dans lequel un état anormal dans le couple moteur-pompe (100) est déterminé en fonction de la présence de chacun des premier et second indicateurs de défaut dans les spectres de puissance et de courant respectifs du couple moteur-pompe (100), et
un système d'entraînement (104) configuré pour commander le couple moteur-pompe (100), le système d'entraînement (104) étant en communication avec le système de traitement de détection de cavitation (105) ;
dans lequel le système de traitement de détection de cavitation (104) est en outre configuré pour transmettre un signal de déclenchement, basé sur l'analyse de la signature électrique, à l'unité d'entraînement (104), afin de réduire une vitesse de fonctionnement du couple moteur-pompe (100) ; et
dans lequel le système de traitement de détection de cavitation (105) est en outre configuré pour analyser en continu la signature électrique après l'émission de chaque signal de déclenchement, et pour continuer à transmettre le signal de déclenchement au système d'entraînement (104) tant que la présence de chacun des premier et second indicateurs de défaut est détectée.

11. Système de commande du fonctionnement du couple moteur-pompe (100) selon la revendication 10, dans lequel l'état anormal dans le couple moteur-pompe (100) inclut la présence d'un blocage dans le couple moteur-pompe (100) et/ou la présence de cavitation dans la pompe centrifuge (101).

12. Système de commande du fonctionnement du couple moteur-pompe (100) selon la revendication 10 ou la revendication 11, dans lequel il est déterminé que l'état anormal dans le couple moteur-pompe (100) correspond à la présence d'un blocage dans le couple moteur-pompe (100), lorsque le spectre basse fréquence inclut la présence de bruit englobant une région de fréquence plus large.

13. Système de commande du fonctionnement du couple moteur-pompe (100) selon l'une quelconque des revendications 10 à 12, dans lequel il est déterminé que l'état anormal dans le couple moteur-pompe (100) correspond à la présence de cavitation dans la pompe centrifuge (101), lorsque le spectre basse fréquence inclut la présence d'une région de fréquence plus étroite, inférieure à la moitié d'une région de fréquence correspondant à la présence d'un blocage dans le couple moteur-pompe (100).
